# FASCICULE DE BREVET EUROPEEN

(11) **EP 2 581 339 B1**
(45) Date de publication et mention de la délivrance du brevet: **16.03.2016**
(21) Numéro de dépôt: 12187748.4
(22) Date de dépôt: 09.10.2012
(51) Int. Cl.: B81C 1/00

(54) **Structure d'encapsulation de dispositif électronique et procédé de réalisation d'une telle structure**
Einkapselungsstruktur einer elektronischen Vorrichtung und Herstellungsverfahren einer solchen Struktur
Electronic device encapsulation structure and method for making such a structure

(30) Priorité: 11.10.2011 FR 1159168
(43) Date de publication de la demande: 17.04.2013
(73) Titulaire: Commissariat à l'Énergie Atomique et aux Énergies Alternatives, 75015 Paris (FR)
(72) Inventeur: Pronin, Jean-Louis, 38920 Crolles (FR); Dumont, Geoffroy, 75011 Paris (FR)
(74) Mandataire: Ilgart, Jean-Christophe

(56) Documents cités:
- EP-A1- 1 878 693
- EP-A2- 1 585 371
- WO-A2-2004/006290
- US-A- 5 293 511
- US-A1- 2005 227 114
- US-A1- 2007 026 559
- US-B1- 6 499 354

## Description

### DOMAINE TECHNIQUE

L'invention concerne une structure d'encapsulation d'au moins un dispositif électronique, par exemple de type MEMS (microsystème électromécanique), NEMS (système électromécanique nanométrique) ou encore MOEMS (microsystème opto-électromécanique), encapsulé dans une première cavité et qui comporte un matériau getter disposé dans une deuxième cavité adjacente et communiquant avec la première cavité, ainsi qu'un procédé de réalisation d'une telle structure d'encapsulation.

L'invention est avantageusement mise en oeuvre pour assurer l'encapsulation individuelle hermétique, c'est-à-dire étanche vis-à-vis de fluides et/ou de gaz, par exemple sous vide, de plusieurs dispositifs microélectroniques assemblés en matrice sur un support (par exemple un substrat) et pour lesquels on cherche à maximiser les surfaces dédiées aux dispositifs afin d'optimiser les performances des dispositifs. Dans ce type de packaging, les dispositifs microélectroniques sont encapsulés individuellement dans des premières cavités séparées les unes des autres par des espaces servant de deuxièmes cavités dans lesquelles des portions de matériau getter sont disposées. L'invention permet donc d'utiliser ces espaces perdus entre les premières cavités dans lesquelles les dispositifs microélectroniques sont encapsulés.

### ÉTAT DE LA TECHNIQUE ANTÉRIEURE

Il est connu d'encapsuler un dispositif microélectronique, par exemple un capteur, en mettant en oeuvre un procédé de type PCM (Packaging Couche Mince), assurant au dispositif de bonnes conditions de pression pour fonctionner. Ce procédé fait appel à une couche sacrificielle, par exemple composée de résine, qui est déposée sur le dispositif puis gravée selon la forme de la cavité souhaitée. Le capot est ensuite réalisé en déposant une couche mince, par exemple composée de SiO₂, sur la couche sacrificielle. Enfin, la couche sacrificielle est éliminée au travers d'un ou plusieurs trous de libération formés à travers le capot. Ces trous sont ensuite bouchés pour assurer l'herméticité de la cavité ainsi réalisée.

Lorsque le dispositif est un dispositif optique destiné à émettre et/ou recevoir de la lumière, par exemple un détecteur de type micro-bolomètre, il est parfois nécessaire que celui-ci soit disposé dans une atmosphère sous vide (par exemple sous vide poussé ou vide secondaire, c'est-à-dire dont la pression est comprise entre environ 10⁻³ mbar et 10⁻⁷ mbar) . Un tel vide est obtenu généralement en introduisant dans la cavité un matériau à effet getter, c'est-à-dire un matériau apte à réaliser une absorption et/ou une adsorption gazeuse dans la cavité. Parallèlement à cela, il est également nécessaire, lorsque le dispositif microélectronique est destiné à émettre et/ou recevoir de la lumière, de ne rien introduire d'opaque vis-à-vis de la ou des longueurs d'ondes destinées à être émises et/ou reçues par le dispositif, sur la trajectoire lumineuse du dispositif.

Pour cela, le document FR 2 826 725 propose de disposer le matériau à effet getter sous le dispositif microélectronique ou sur les parois internes de la cavité. Cette solution présente toutefois l'inconvénient que le matériau getter est en contact avec des matériaux du dispositif lors des étapes technologiques de réalisation du dispositif, ce qui peut avoir pour effet de dégrader ou même supprimer l'effet getter attendu.

Une deuxième solution consiste à déposer le matériau getter dans la cavité, sur le substrat et à coté du dispositif microélectronique. Cette deuxième solution a toutefois pour inconvénient de réduire la surface du substrat dédiée au dispositif microélectronique, ce qui entraine soit une baisse des performances du dispositif (à surface d'occupation du substrat constante), soit une hausse de la taille du dispositif (et donc une hausse du coût du dispositif car un nombre moins important de dispositifs microélectroniques sont réalisés sur la plaque de semi-conducteur servant de substrat)

Le document EP 1 878 693 A1 divulgue également un dispositif utilisant un matériau getter.

### EXPOSÉ DE L'INVENTION

Un but de la présente invention est de proposer une nouvelle structure d'encapsulation d'au moins un dispositif électronique permettant de préserver les propriétés d'absorption et/ou d'adsorption gazeuse du matériau getter, qui permette de réaliser le matériau getter en dehors du champ optique lorsque le dispositif électronique est destiné à émettre et/ou recevoir de la lumière, tout en maximisant la surface dédiée au dispositif électronique sur le support.

Pour cela, la présente invention propose une structure d'encapsulation d'au moins un dispositif électronique, comportant au moins une première cavité délimitée par un support et au moins un capot disposé sur le support et dans laquelle est encapsulé le dispositif électronique, le capot étant traversé par au moins une ouverture faisant communiquer l'intérieur de la première cavité avec au moins une portion de matériau getter disposée dans au moins une deuxième cavité adjacente à la première cavité, au moins une partie de ladite portion de matériau getter étant disposée sur le support et/ou contre au moins une paroi latérale extérieure de la première cavité, la première cavité et la deuxième cavité formant ensemble un volume, ou espace, fermé hermétiquement.

Du fait que le matériau getter est déposé dans une deuxième cavité, en dehors du volume intérieur de la première cavité correspondant à l'espace entre le capot et le support dans lequel est disposé le dispositif électronique, celui-ci ne subit pas de dégradation liée à la mise en oeuvre des étapes technologiques de réalisation du dispositif électronique et de la première cavité, du fait que le matériau getter peut être déposé après avoir réalisé le dispositif électronique et la première cavité dans laquelle le dispositif électronique est encapsulé.

De plus, étant donné que le matériau getter se trouve hors de la première cavité, sur une surface du support par exemple dédiée à la séparation des dispositifs électroniques, la surface du support à l'intérieur de la première cavité est entièrement dédiée au dispositif électronique et n'est pas réduite par la présence du matériau getter.

La surface de matériau getter utilisée n'est pas non plus limitée par le volume de la première cavité, ce qui permet d'augmenter de manière importante la surface de matériau getter destinée à réaliser une absorption et/ou une adsorption des gaz présents dans la première cavité, améliorant par exemple le niveau de vide pouvant régner dans la première cavité, qui pourra passer de la pression de fermeture qui peut être de l'ordre d'un millibar, à une pression de l'ordre d'environ 10⁻³ mbar correspondant généralement au point de fonctionnement du dispositif par exemple de type MEMS, ainsi que la durée de vie du dispositif électronique, après activation du getter.

Du fait que la première cavité et la deuxième cavité forment un volume, ou espace, fermé hermétiquement, le matériau getter disposé dans la deuxième cavité permet d'assurer le maintien de la pression de fonctionnement du dispositif électronique qui peut être encapsulé individuellement dans la première cavité. Une telle encapsulation individuelle permet d'éviter qu'une fuite d'herméticité au niveau de l'encapsulation d'un des dispositifs ne rende inutilisable d'autres dispositifs réalisés sur le même support et qui seraient encapsulés collectivement, comme par exemple dans le cas d'une matrice de capteurs.

Grâce à la structure d'encapsulation selon l'invention, il est par exemple possible d'utiliser des espaces libres présents entre différentes premières cavités dans lesquelles plusieurs dispositifs électroniques sont encapsulés individuellement pour y déposer le matériau getter, et cela sans affecter les zones du support dédiées aux dispositifs électroniques et sans avoir à mettre en communication les différentes cavités, ces espaces libres formant les deuxièmes cavités qui sont adjacentes aux premières cavités.

Lorsque le matériau getter est formé au moment de la fermeture de la deuxième cavité, celui-ci n'est pas dégradé ni contaminé, et la pression de fermeture peut être plus basse du fait de la présence de l'effet getter au moment de cette fermeture.

Enfin, la forme et les dimensions du capot peuvent être adaptées à la forme du dispositif électronique pour optimiser la surface dédiée au matériau getter.

La ou les deuxièmes cavités peuvent être réalisées sur le support, notamment à côté de la ou des premières cavités. On optimise ainsi l'espace disponible sur le support pour former les première et deuxième cavités sans augmenter l'épaisseur globale de la structure d'encapsulation.

Le matériau getter peut être déposé contre une ou plusieurs parois latérales extérieures de la première cavité, augmentant ainsi la surface de matériau getter déposé.

L'intérieur de la première cavité communique avec l'intérieur de la deuxième cavité, c'est-à-dire avec la portion de matériau getter, via l'ouverture. Les gaz présents dans la première cavité peuvent entrer en contact avec la portion de matériau getter en traversant l'ouverture.

Le terme « dispositif électronique » désigne ici tout type de dispositif, préférentiellement de dimensions micrométriques comme par exemple des dispositifs de type MEMS ou MOEMS, mais également des dispositifs électroniques de dimensions nanométriques tels que des NEMS ou encore des dispositifs électroniques et/ou électriques de dimensions plus importantes.

Le volume, ou l'espace, formé par la première cavité et la deuxième cavité peut être fermé hermétiquement par la portion de matériau getter. Dans une variante, il est possible qu'un matériau autre que le matériau getter serve de bouchon pour fermer hermétiquement ce volume.

L'ouverture peut traverser une surface du capot qui est sensiblement perpendiculaire par rapport à un plan principal du support. Un tel plan principal peut correspondre à la face du support sur laquelle est réalisé le dispositif électronique.

L'intérieur de la première cavité peut communiquer avec la portion de matériau getter via au moins un espace formant un canal entre la première cavité et la deuxième cavité, l'ouverture pouvant être telle qu'elle débouche dans le canal. Dans ce cas, la première cavité et la deuxième cavité peuvent communiquer ensemble au moins via l'ouverture et le canal. Un tel canal permet, lors de la fermeture du volume formé par la première cavité et la deuxième cavité par le matériau getter ou un autre matériau de bouchage, d'empêcher le ou les matériaux de bouchage de pénétrer à l'intérieur de la première cavité et de se déposer sur le dispositif électronique.

Au moins une deuxième partie de la portion de matériau getter peut boucher au moins une deuxième ouverture formant un accès au canal ou à la première ouverture. Cette deuxième ouverture peut être réalisée à travers une portion de matériau délimitant, avec le capot, le canal.

La deuxième partie de la portion de matériau getter peut être recouverte par une couche d'herméticité.

La structure d'encapsulation peut comporter une pluralité de dispositifs électroniques encapsulés dans des premières cavités distinctes délimitées par le support et des capots disposés sur le support, les capots étant traversés par des ouvertures faisant communiquer l'intérieur des premières cavités avec une ou plusieurs portions de matériau getter disposées dans une ou plusieurs deuxièmes cavités juxtaposées et/ou formées entre les premières cavités, au moins une partie de ladite ou desdites portions de matériau getter étant disposée sur le support et/ou contre une ou plusieurs parois latérales extérieures des premières cavités.

Ainsi, la structure d'encapsulation peut former une structure matricielle de dispositifs électroniques à cavités hermétiques comportant sur un support :
- un ensemble de dispositifs électroniques à cavités hermétiques comportant respectivement au moins une ouverture libre,
- au moins un matériau getter disposé dans les espaces latéraux entre les premières cavités, ces espaces latéraux formant les deuxièmes cavités,
- une couche de fermeture disposée sur les cavités de façon à ce que chaque première cavité soit étanche indépendamment des autres premières cavités tout en restant en communication avec le getter disposé dans les espaces entre les premières cavités.

Les intérieurs de plusieurs premières cavités peuvent communiquer ensemble via les ouvertures traversant les capots desdites premières cavités.

La structure d'encapsulation peut comporter en outre une couche de matériau getter fermant hermétiquement le ou les volumes, ou espaces, formés par les premières cavités et la ou les deuxièmes cavités.

La présente invention concerne également un procédé de réalisation d'une structure d'encapsulation d'au moins un dispositif électronique, comportant au moins les étapes de :
- réalisation du dispositif électronique sur un support,
- réalisation d'au moins un capot sur le support, formant une première cavité délimitée par le support et le capot et dans laquelle est encapsulé le dispositif électronique,
- réalisation d'au moins une ouverture à travers le capot,
- dépôt d'au moins une portion de matériau getter dans au moins une deuxième cavité adjacente à la première cavité, l'ouverture faisant communiquer l'intérieur de la première cavité avec la portion de matériau getter, au moins une partie de ladite portion de matériau getter étant disposée sur le support et/ou contre au moins une paroi latérale extérieure de la première cavité, la première cavité et la deuxième cavité formant ensemble un volume, ou espace, fermé hermétiquement.

La portion de matériau getter peut être déposée telle qu'elle ferme hermétiquement le volume, ou l'espace, formé par la première cavité et la deuxième cavité.

Le procédé peut comporter en outre, entre la réalisation de l'ouverture à travers le capot et le dépôt de la portion de matériau getter, la réalisation d'au moins un espace formant un canal entre la première cavité et la deuxième cavité et destiné faire communiquer l'intérieur de la première cavité avec la portion de matériau getter, l'ouverture étant telle qu'elle débouche dans le canal.

Le dépôt de la portion de matériau getter peut être réalisé tel qu'au moins une deuxième partie de la portion de matériau getter bouche au moins une deuxième ouverture formant un accès au canal ou à la première ouverture, et fermant hermétiquement le volume, ou l'espace, formé par la première cavité et la deuxième cavité.

Le procédé peut comporter en outre, après le dépôt de la portion de matériau getter, une étape de dépôt d'une couche d'herméticité recouvrant la deuxième partie de la portion de matériau getter.

Le procédé peut comporter la réalisation d'une pluralité de dispositifs électroniques et d'une pluralité de capots sur le support, encapsulant les dispositifs électroniques dans des premières cavités distinctes délimitées par le support et les capots, le procédé comportant en outre la réalisation d'une pluralité d'ouvertures à travers les capots et le dépôt d'une ou plusieurs portions de matériau getter dans une ou plusieurs deuxièmes cavités formées entre les premières cavités, les ouvertures faisant communiquer l'intérieur des premières cavités avec la ou les portions de matériau getter, au moins une partie de ladite ou desdites portions de matériau getter étant disposées sur le support et/ou contre une ou plusieurs parois latérales extérieures des premières cavités.

Les ouvertures peuvent être réalisées telles que l'intérieur de plusieurs premières cavités communique via les ouvertures traversant les capots desdites premières cavités.

Le procédé peut comporter en outre la réalisation d'une couche de matériau getter fermant hermétiquement le ou les volumes, ou espaces, formés par les premières cavités et la ou les deuxièmes cavités.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une structure d'encapsulation d'un dispositif électronique, objet de la présente invention, selon un premier mode de réalisation,
- les figures 2A à 2G représentent les étapes d'un procédé de réalisation d'une structure d'encapsulation de plusieurs dispositifs électroniques, objet de la présente invention, selon un deuxième mode de réalisation,
- les figures 3A et 3B représentent une structure d'encapsulation de plusieurs dispositifs électroniques, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

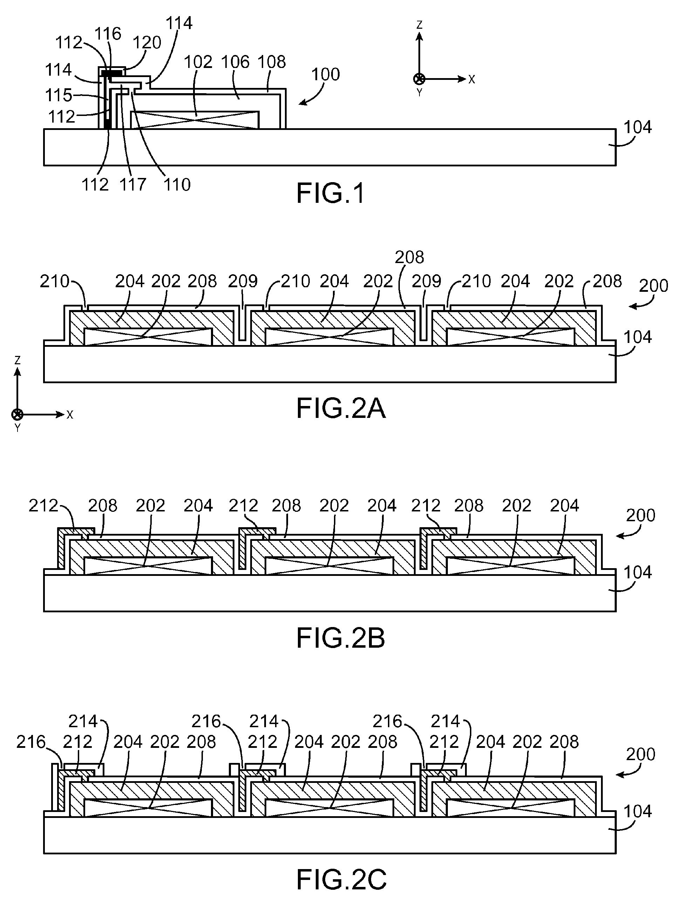

On se réfère tout d'abord à la figure 1 qui représente une structure d'encapsulation 100 d'un dispositif électronique 102, correspondant ici à un micro-bolomètre, selon un premier mode de réalisation.

Le dispositif 102 est réalisé sur un support 104 correspondant ici à un substrat de silicium, et est encapsulé dans une première cavité 106 formée entre le support 104 et un capot 108, par exemple réalisé en couche mince par un procédé de type PCM et composé d'un matériau, tel que du silicium amorphe ou du SiO₂. Le capot 108 peut être à base de n'importe quel matériau, par exemple diélectrique, semi-conducteur ou encore électriquement conducteur.

Le capot 108 comporte une ou plusieurs ouvertures 110 (une seule ouverture 110 est représentée sur la figure 1) formées à travers le capot 108. Une portion de matériau 114, par exemple composée du même matériau que celui formant le capot 108, et réalisée sur le capot 108 et à côté de celui-ci, forme une deuxième cavité 115 adjacente à la première cavité 106 et communiquant avec celle-ci via un canal 117 et l'ouverture 110. Les deux cavités 106 et 115 sont formées sur le support 104 l'une à côté de l'autre. On voit également sur la figure 1 qu'au moins une paroi latérale extérieure de la première cavité 106 forme au moins l'une des parois latérales intérieures de la deuxième cavité 115.

Une portion de matériau getter 112, par exemple composée de titane ou de tout autre matériau, tel qu'un métal ou un alliage métallique, apte à réaliser une absorption et/ou une adsorption gazeuse, est déposée dans la deuxième cavité 115. La portion de matériau getter 112 est déposée sur le support 104, au fond de la deuxième cavité 115 ainsi que contre les parois latérales de la deuxième cavité 115 (et donc contre au moins une paroi latérale extérieure de la première cavité 106 car ici, une même portion de matériau forme une des parois latérales extérieures de la première cavité 106 et une des parois latérales intérieures de la deuxième cavité 115). Une partie de la portion de matériau getter 112 repose également sur une partie de la portion de matériau 114, fermant ainsi une ouverture 116 réalisée à travers la portion de matériau 114. Cette partie de la portion de matériau getter 112 est recouverte par une couche d'herméticité 120 empêchant le contact des gaz extérieurs avec la portion de matériau getter 112. La couche d'herméticité 120 ferme ici hermétiquement le volume, ou l'espace, formé par la deuxième cavité 115 et la première cavité 106. Après l'activation thermique du matériau getter 112, ce dernier n'absorbe et/ou n'adsorbe donc que les gaz se trouvant dans ce volume, ou cet espace, clos.

Bien qu'une seule ouverture 110 soit représentée sur la figure 1, il est possible que plusieurs ouvertures, par exemple similaires à l'ouverture 110 représentée sur la figure 1, soient réalisées à travers le capot 108 et fassent communiquer le volume intérieur de la première cavité 106 avec du matériau getter déposé hors de la première cavité 106, dans une ou plusieurs deuxièmes cavités par exemple similaires à la deuxième cavité 115, par l'intermédiaire de ces ouvertures 110.

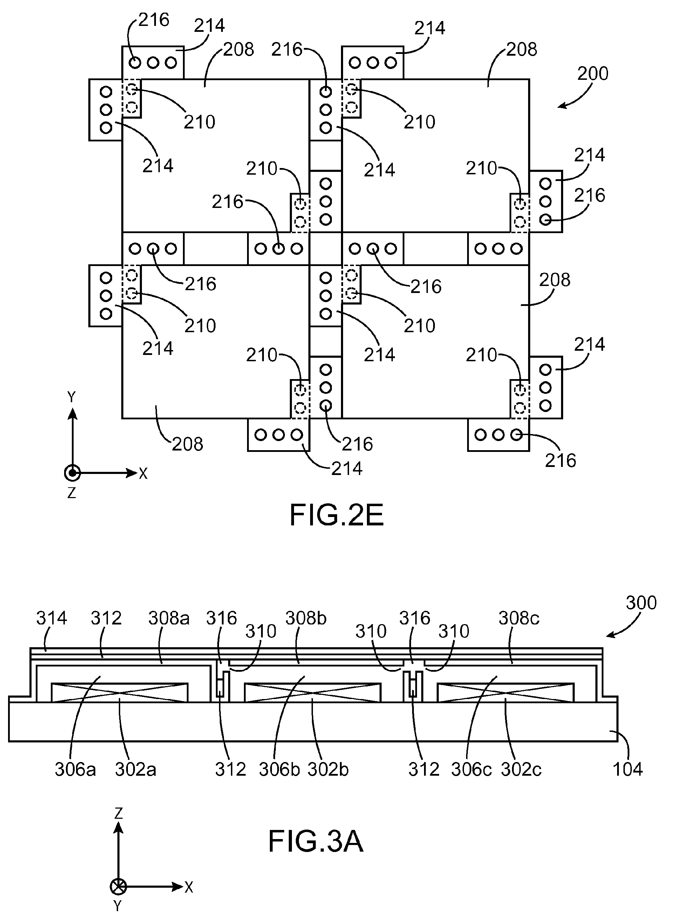

On se réfère maintenant aux figures 2A à 2G représentant les étapes de réalisation d'une structure d'encapsulation 200 selon un deuxième mode de réalisation.

Dans ce deuxième mode de réalisation, la structure 200 réalise une encapsulation individuelle de plusieurs dispositifs électroniques 202 réalisés sur le support 104 et répartis sur le support 104 sous la forme d'une matrice. Lorsque les dispositifs électroniques 202 sont des capteurs optiques tels que des micro-bolomètres, chaque dispositif électronique 202 peut correspondre à un pixel de la matrice de micro-bolomètres obtenue.

Le support 104 et les dispositifs électroniques 202 sont tout d'abord recouverts par une couche sacrificielle par exemple composée de résine et mise en forme par photolithographie et gravure afin que chaque dispositif 202 soit recouvert par une portion 204 de matériau sacrificiel définissant le futur volume d'une première cavité 206 dans laquelle le dispositif 202 est destiné à être encapsulé.

On réalise ensuite un dépôt conforme d'une couche composée par exemple d'un matériau diélectrique tel que du silicium amorphe, destinée à former des capots 208 encapsulant les dispositifs 202. Ce dépôt est qualifié de conforme car il recouvre avec une épaisseur sensiblement constante l'ensemble des surfaces exposées des portions 204 de matériau sacrificiel, c'est-à-dire les faces supérieures et les parois latérales de ces portions 204, formant ainsi les capots 208 qui sont destinés à délimiter, avec le support 104, les premières cavités 206 dans lesquelles les dispositifs 202 seront encapsulés. Ce matériau est également déposé entre les portions 204, sur le support 104. La couche déposée formant les capots 208 a de préférence une épaisseur comprise entre environ 1 µm et quelques micromètres, par exemple 10 µm. Chaque capot 208 est espacé des capots voisins par des espaces libres 209 par exemple de largeur comprise entre environ 1 et 2 µm, destinés à former les deuxièmes cavités dans lesquelles du matériau getter sera déposé.

Des ouvertures 210 sont ensuite réalisées à travers les capots 208, formant des accès aux portions 204 de matériau sacrificiel, c'est-à-dire des trous de libération (figure 2A). Comme cela est visible sur l'exemple de la figure 2E, chaque capot 208 est traversé par quatre ouvertures 210 formées au niveau de deux bords supérieurs du capot 208.

Comme représenté sur la figure 2B, une deuxième couche de matériau sacrificiel, par exemple de nature similaire à celui utilisé pour réaliser les portions 204, est déposée sur l'ensemble des éléments précédemment réalisés, recouvrant ainsi les capots 208. Le matériau sacrificiel de cette deuxième couche est notamment déposé dans les ouvertures 210 ainsi que dans les espaces libres 209 entre les capots 208. La deuxième couche de matériau sacrificiel est ensuite soumise à des étapes de photolithographie et de gravure, formant des secondes portions de matériau sacrificiel 212. Chacune de ces secondes portions de matériau sacrificiel 212 remplit un des espaces libres 209 destinés à former les deuxièmes cavités dans lesquelles du matériau getter est destiné à être déposé. De plus, chacune des secondes portions de matériau sacrificiel 212 occupe également un volume (au-dessus des capots 208 sur l'exemple de la figure 2C) destiné à former un canal, ou « chicane », qui permettra de faire communiquer l'intérieur de l'une des premières cavités avec la portion de matériau getter qui sera déposé dans la partie de l'espace libre 209 occupée par la seconde portion de matériau sacrificiel 212, c'est-à-dire à faire communiquer l'une des premières cavités 206 avec l'une des deuxièmes cavités.

Une ou plusieurs ouvertures 210 (destinées à déboucher dans ce canal) sont également remplies par le matériau sacrificiel de la seconde portion 212.

Une couche de matériau, par exemple similaire à celui utilisé pour réaliser les capots 208, est déposée en recouvrant notamment les secondes portions de matériau sacrificiel 212. Cette couche peut éventuellement être gravée afin de ne conserver que des portions 214 recouvrant les secondes portions de matériau sacrificiel 212.

Des secondes ouvertures 216 sont réalisées à travers ces portions 214, en regard des parties des secondes portions de matériau sacrificiel 212 remplissant les parties des espaces libres 209 entre les capots 208 (figure 2C). Les secondes ouvertures 216 vont servir de trous de libération pour éliminer les secondes portions de matériau sacrificiel 212 ainsi que les portions sacrificielles 204 à travers les canaux 217 obtenus en gravant les secondes portions de matériau sacrificiel 212 et à travers les ouvertures 210. Le matériau getter sera ensuite déposé à travers ces secondes ouvertures 216, dans les deuxièmes cavités 215 délimitées par le matériau 214. Comme cela est visible sur l'exemple de la figure 2E, chaque capot 208 est en partie recouvert par deux portions de matériau 214, et chacune de ces deux portions de matériau 214 recouvre deux ouvertures 210 formées à travers le capot 208, six secondes ouvertures 216 étant réalisées à travers chacune de ces portions de matériau 214.

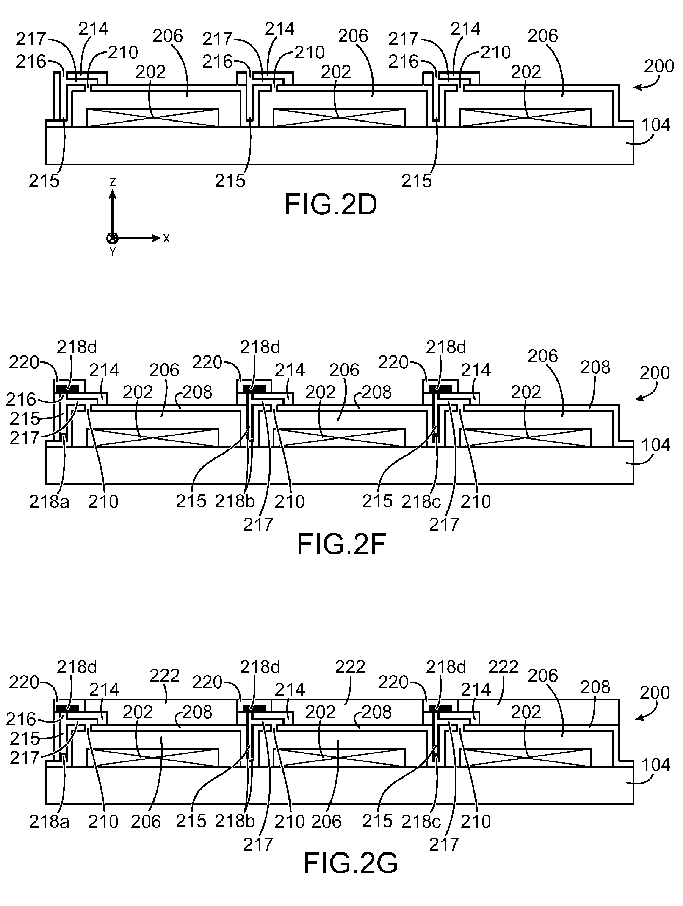

Les secondes portions de matériau sacrificiel 212 sont supprimées par exemple par une gravure plasma à travers les secondes ouvertures 216, libérant ainsi les parties des espaces 209 entre les capots 208 (ou entre les premières cavités 206) destinées à recevoir du matériau getter, c'est-à-dire formant les deuxièmes cavités 215. Les espaces libérés entre les portions 214 et les capots 208 forment également des canaux 217 qui serviront à faire communiquer le matériau getter disposé dans les deuxièmes cavités 215 avec l'intérieur des premières cavités 206. Cette gravure plasma supprime également les portions de matériau sacrificiel 204, libérant ainsi les dispositifs 202 et formant les premières cavités 206, entre les capots 208 et le support 104, dans lesquelles sont encapsulés les dispositifs 202 (figure 2D). Les secondes ouvertures 216 se trouvent en regard des parties des deuxièmes cavités 215 entre les différents capots 208 destinées à recevoir du matériau getter. Les canaux 217 font communiquer, au niveau de chaque capot 208, les ouvertures 210 et 216 bien que celles-ci ne soient pas alignées l'une au-dessus de l'autre dans le plan du support 104 (plan parallèle au plan (X,Y) représenté sur la figure 2D). Les premières cavités 206 et les deuxièmes cavités 215 sont disposées sur le support 104 les unes à côté des autres.

La figure 2E représente une vue de dessus de l'ensemble réalisé. Sur cette figure, on voit que chaque capot 208 est traversé par quatre ouvertures 210 formées au niveau de deux bords supérieurs du capot 208 et couplées à douze secondes ouvertures 216 par l'intermédiaire des canaux 217. On voit également sur cette figure que deux parois latérales intérieures de chacune des deuxièmes cavités 215 correspondent à des parois latérales extérieures de deux premières cavités 206 adjacentes à la deuxième cavité 215.

Comme représenté sur la figure 2F, on réalise ensuite un dépôt de matériau getter 218 dans les deuxièmes cavités 215 délimitées par les portions 214, à travers les ouvertures 216. Du fait que les ouvertures 210 traversant les capots 208 sont déportées par rapport aux secondes ouvertures 216, le matériau getter 218 ne se dépose pas dans les premières cavités 206. Le matériau getter peut être déposé soit au fond des deuxièmes cavités 215, sur les portions de matériau formant les capots 208 et déposées sur le support 104, entre les capots 208 (comme c'est le cas pour la portion 218a), ou contre les flancs latéraux des capots 208 (cas des portions 218b), ou encore les deux (cas de la portion 218c). Il est également possible que du matériau getter remplisse l'ensemble des deuxièmes cavités 215 délimitées par les portions de matériau 214. La configuration dans laquelle sera déposé le matériau getter sera fonction des dimensions des secondes ouvertures 216 dans le plan du support 104 (parallèle au plan (X,Y)) par rapport à celles des deuxièmes cavités 215 dans ce même plan délimitées par les capots 208 et les portions de matériau 214, ainsi que de la position de ces secondes ouvertures 216 par rapport aux deuxièmes cavités 215. Par exemple, si les dimensions des secondes ouvertures 216 sont sensiblement similaires à celles des deuxièmes cavités 215 (par exemple dans le cas de bords des ouvertures 216 tangents aux flancs latéraux des capots 208), le matériau getter peut se déposer contre les flancs latéraux des capots 208 et éventuellement au fond des deuxièmes cavités 215. Si les ouvertures 216 ont des dimensions inférieures, le matériau getter peut n'être déposé qu'au fond des deuxièmes cavités 215, sur le substrat 104. Lors du dépôt du matériau getter, des portions 218d de matériau getter se forment également au-dessus des portions 214 et bouchent les secondes ouvertures 216.

Ces portions 218d de matériau getter peuvent ensuite être recouvertes par une couche d'herméticité 220. Lorsque les dispositifs 202 sont des dispositifs optiques destinés à émettre et/ou recevoir de la lumière, le matériau getter précédemment déposé et la couche d'herméticité 220 peuvent être photolithographiés et gravés afin que le champ optique des dispositifs 202 ne soit pas obstrué par le matériau getter ou la couche d'herméticité 220. Enfin, l'ensemble est recouvert d'une couche antireflet 222, par exemple composée d'un multicouche comprenant des couches de germanium et de sulfure de zinc (figure 2G).

La structure d'encapsulation 200 réalisée forme donc une structure matricielle de dispositifs microélectroniques 202 encapsulés dans des premières cavités hermétiques 206 dont les espaces intérieurs communiquent avec des espaces latéraux entre les cavités formant des deuxièmes cavités 215 dans lesquelles des portions de matériau getter 218 sont disposées, réalisant une absorption et/ou une adsorption gazeuse dans les premières cavités 206.

La configuration des ouvertures 210 et 216 précédemment décrite est un exemple de réalisation. De manière générale, chaque capot 208 peut être traversé par une ou plusieurs ouvertures 210 faisant communiquer l'intérieur de la première cavité 206 avec une deuxième cavité adjacente dans laquelle est disposé un matériau getter. Les ouvertures 216 et 210 peuvent être de sections, dans un plan parallèle à celui du support 104, de forme circulaire, oblong, ou réalisées sous la forme de fentes ou de toute autre forme. De plus, pour chaque première cavité 206, plusieurs ouvertures 210 ou 216 peuvent être réalisées les unes à côté des autres formant ainsi un alignement d'ouvertures entourant au moins en partie la première cavité 206. Le nombre et les dimensions des ouvertures 210 et 216 associées à chaque première cavité 206 seront adaptées en fonction de l'espace disponible, à la capacité d'absorption et/ou d'adsorption souhaitée du matériau getter, etc.

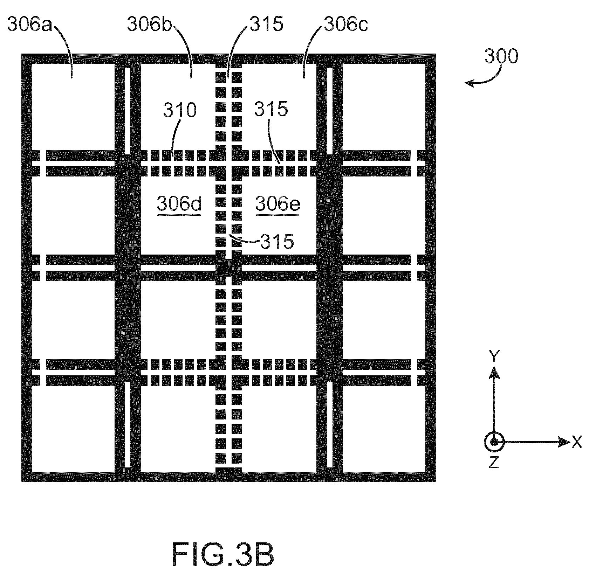

Les figures 3A et 3B représentent une structure d'encapsulation 300 selon un troisième mode de réalisation.

Dans ce troisième mode de réalisation, la structure d'encapsulation 300 comporte plusieurs dispositifs électroniques 302 (dispositifs 302a, 302b, 302c représentés sur la figure 3A), par exemple similaires aux dispositifs 102 et 202 précédemment décrits, chacun encapsulé dans une première cavité 306 formée entre le substrat 104 et un capot 308. Comme dans les précédents modes de réalisation, les capots 308 sont traversés par des ouvertures 310 faisant communiquer l'intérieur des premières cavités 306 avec un matériau getter 312 disposé dans des espaces formés entre plusieurs cavités 306 et correspondant à des deuxièmes cavités 315.

Les ouvertures 310 sont ici réalisées à travers les bords supérieurs des capots 308, c'est-à-dire pour chaque ouverture 310, au niveau d'une jonction entre une paroi supérieure du capot 308 et l'une des parois latérales du capot 308 telle que, lorsque le matériau getter 312 est déposé, pas ou très peu de matériau getter se retrouve à l'intérieur des premières cavités 306. Une petite partie du matériau getter 312 peut être déposée contre les parois latérales du capot, à l'intérieur des premières cavités 306.

Une couche de matériau getter 312 recouvre également les capots 308, bouchant ainsi des secondes ouvertures 316 faisant communiquer l'intérieur de plusieurs premières cavités 306 adjacentes via les ouvertures 310. La couche de matériau getter est recouverte par une couche d'herméticité 314 par exemple de nature similaire à la couche d'herméticité 220.

Contrairement aux autres modes de réalisation, les ouvertures 310 font communiquer l'intérieur de plusieurs premières cavités 306 entre elles. Sur l'exemple des figures 3A et 3B, on voit que les ouvertures 310 formées à travers les parois latérales des capots 308 des cavités 306b, 306c, 306d et 306e font communiquer les intérieurs de ces quatre premières cavités entre elles ainsi qu'avec les deuxièmes cavités 315 formées entre les parois latérales extérieures des premières cavités dans lesquelles du matériau getter 312 est disposé (non représenté sur la figure 3B). La structure d'encapsulation 300 forme donc un ensemble de sous-matrices (dans l'exemple des figures 3A et 3B, chaque sous-matrice est formée par un carré de 2 x 2 dispositifs 302 encapsulés dans des premières cavités 306 communiquant toutes les quatre entre elles).

Les ouvertures 310 sont réalisées au niveau des bords supérieurs des capots 308 telles que, lorsque le matériau getter 312 est déposé, pas ou très peu de matériau getter se retrouve à l'intérieur des premières cavités 306. On évite le dépôt de matériau getter 312 dans les premières cavités 306 grâce au fait que, au niveau des ouvertures 310, les parois supérieures des capots 308 ne sont pas en retraits, dans le plan (X,Y), par rapport à l'intérieur des parois latérales de ces capots 308. Autrement dit, les ouvertures 310 sont formées à travers des surfaces des capots 308 qui sont perpendiculaire par rapport au plan principal du support 104 (plan parallèle au plan (X,Y)), ce plan principal correspondant à la face du support 104 sur laquelle sont réalisés les dispositifs microélectroniques 302. Ainsi, grâce à de telles ouvertures 310, on met en communication des premières cavités adjacentes et on réalise le dépôt de matériau getter 312 entre les premières cavités 306, dans les deuxièmes cavités 315 en évitant de déposer du matériau getter dans les premières cavités 306 sans faire appel à des ouvertures comportant des chicanes (ou canaux) comme précédemment décrit pour les structures d'encapsulation 100 et 200.

Les premières cavités 306 et les deuxièmes cavités 315 sont disposées sur le support 104 les unes à côté des autres. De plus, des parois latérales intérieures de chacune des deuxièmes cavités 315 correspondent à des parois latérales extérieures des premières cavités 306 adjacentes à la deuxième cavité 315.

En variante, il est possible que la structure d'encapsulation 300 comporte des cavités 306 traversées par des ouvertures similaires aux ouvertures 210 précédemment décrites, c'est-à-dire comportant des canaux. Lorsque de telles ouvertures et canaux sont réalisés les uns en face des autres, il est possible d'avoir également une communication entre des premières cavités adjacentes via ces ouvertures et ces canaux.

## Revendications

1. Structure d'encapsulation (100, 200, 300) de plusieurs dispositifs électroniques (102, 202, 302a - 302c) dans des premières cavités (106, 206, 306a - 306c) séparées les unes des autres par au moins un espace formant une deuxième cavité (115, 215, 315), telle que :
- chacune des premières cavités (106, 206, 306a - 306c) est délimitée par un support (104) et au moins un capot (108, 208, 308a - 308c) disposé sur le support (104) et dans laquelle est encapsulé au moins l'un des dispositifs électroniques (102, 202, 302a - 302c),
- au moins une portion de matériau getter (112, 218a - 218d, 312) est disposée dans la deuxième cavité (115, 215, 315), la deuxième cavité (115, 215, 315) étant disposée sur le support (104) et adjacente à au moins l'une des premières cavités (106, 206, 306a - 306c),
dans laquelle :
- le capot (108, 208, 308a - 308c) est traversé par au moins une ouverture (110, 210, 310) faisant communiquer l'intérieur de ladite une des premières cavités (106, 206, 306a - 306c) avec la portion de matériau getter (112, 218a - 218d, 312),
- au moins une partie de ladite portion de matériau getter (112, 218a - 23.8c, 312) est disposée sur le support (104) et/ou contre au moins une paroi latérale extérieure de ladite une des premières cavités (106, 206, 306a - 306c),
- ladite une des premières cavités (106, 206, 306a - 306c) et la deuxième cavité (115, 215, 315) forment ensemble un volume fermé hermétiquement,
- la paroi latérale extérieure de ladite une des premières cavités (106, 206, 306a - 306c) forme au moins une paroi latérale intérieure de la deuxième cavité (115, 215, 315).

2. Structure d'encapsulation (100, 200, 300) selon la revendication 1, dans laquelle le volume formé par ladite une des premières cavités (106, 206, 306a - 306c) et la deuxième cavité (115, 215, 315) est fermé hermétiquement par la portion de matériau getter (112, 218a - 218d, 312).

3. Structure d'encapsulation (300) selon l'une des revendications précédentes, dans laquelle l'ouverture (310) traverse une surface du capot 308a - 308c) qui est sensiblement perpendiculaire par rapport à un plan principal du support (104).

4. Structure d'encapsulation (100, 200) selon l'une des revendications précédentes, dans laquelle l'intérieur de ladite une des premières cavités (106, 206) communique avec la portion de matériau getter (112, 218a - 218d) via au moins un espace formant un canal (117, 217) entre ladite une des premières cavités (106, 206) et la deuxième cavité (115, 215), l'ouverture (110, 210) étant telle qu'elle débouche dans le canal (117, 217).

5. Structure d'encapsulation (100, 200, 300) selon l'une des revendications précédentes, dans laquelle au moins une deuxième partie de la portion de matériau getter (112, 218d, 312) bouche au moins une deuxième ouverture (116, 216, 316) formant un accès au canal (117, 217) ou à la première ouverture (310).

6. Structure d'encapsulation (100, 200, 300) selon la revendication 5, dans laquelle la deuxième partie de la portion de matériau getter (112, 218d, 312) est recouverte par une couche d'herméticité (120, 220, 314).

7. Structure d'encapsulation (200, 300) selon l'une des revendications précédentes, dans laquelle les capots (208, 308a - 308c) sont traversés par des ouvertures (210, 310) faisant communiquer l'intérieur des premières cavités (206, 306a - 306c) avec une ou plusieurs portions de matériau getter (218a - 218d, 312) disposées dans une ou plusieurs deuxièmes cavités (215, 315) formées entre les premières cavités (206, 306a - 306c), au moins une partie de ladite ou desdites portions de matériau getter (218a - 218d, 312) étant disposée sur le support (104) et/ou contre une ou plusieurs parois latérales extérieures des premières cavités (206, 306a - 306c) .

8. Structure d'encapsulation (300) selon la revendication 7, dans laquelle les intérieurs de plusieurs premières cavités (306b, 306c) communiquent ensemble via les ouvertures (310) traversant les capots (308b, 308c) desdites premières cavités (306b, 306c).

9. Structure d'encapsulation (300) selon l'une des revendications 7 ou 8, comportant en outre une couche de matériau getter (312) fermant hermétiquement le ou les volumes formés par les premières cavités (308a-308c) et la ou les deuxièmes cavités (315).

10. Procédé de réalisation d'une structure d'encapsulation (100, 200, 300) de plusieurs dispositifs électroniques (102, 202, 302a - 302c) dans des premières cavités (106, 206, 306a - 306c) séparées les unes des autres par au moins un espace formant une deuxième cavité (115, 215, 315), comportant au moins les étapes de :
- réalisation des dispositifs électroniques (102, 202, 302a - 302c) sur un support (104),
- réalisation, pour chacune des premières cavités (106, 206, 306a - 306c), d'au moins un capot (108, 208, 308a - 308c) sur le support (104), chacune des premières cavités (106, 206, 306a - 306c) étant délimitée par le support (104) et le capot (108, 208, 308a - 308c) et dans laquelle est encapsulé au moins l'un des dispositifs électroniques (102, 202, 302a - 302c) ;
- réalisation d'au moins une ouverture (110, 210, 310) à travers le capot (108, 208, 308a - 308c),
- dépôt d'au moins une portion de matériau getter (112, 218a - 218d, 312) dans la deuxième cavité (115, 215, 315) disposée sur le support (104) et adjacente à au moins l'une des premières cavités (106, 206, 306a - 306c), l'ouverture (110, 210, 310) faisant communiquer l'intérieur de ladite une des premières cavités (106, 206, 306a - 306c) avec la portion de matériau getter (112, 218a 218d, 312), au moins une partie de ladite portion de matériau getter (112, 218a - 218d, 312) étant disposée sur le support (104) et/ou contre au moins une paroi latérale extérieure de ladite une des premières cavités (106, 206, 306a - 306c),
dans lequel ladite une des premières cavités (106, 206, 306a - 306c) et la deuxième cavité (115, 215, 315) forment ensemble un volume fermé hermétiquement, et dans lequel la paroi latérale extérieure de ladite une des premières cavités (106, 206, 306a - 306c) forme au moins une paroi latérale intérieure de la deuxième cavité (115, 215, 315).

11. Procédé selon la revendication 10, dans laquelle la portion de matériau getter (312) est déposée telle qu'elle ferme hermétiquement le volume formé par ladite une des premières cavités (306) et la deuxième cavité (315).

12. Procédé selon la revendication 10, comportant en outre, entre la réalisation de l'ouverture (110, 210) à travers le capot (108, 208) et le dépôt de la portion de matériau getter (112, 218a - 218d), la réalisation d'au moins un espace formant un canal (117, 217) entre ladite une des premières cavités (106, 206) et la deuxième cavité (115, 215) et destiné faire communiquer l'intérieur de ladite une des premières cavités (106, 206) avec la portion de matériau getter (112, 218a - 218d), l'ouverture (110, 210) étant telle qu'elle débouche dans le canal (117, 217).

13. Procédé selon la revendication 12, dans lequel le dépôt de la portion de matériau getter (112, 218a - 218d, 312) est réalisé tel qu'au moins une deuxième partie de la portion de matériau getter (112, 218d, 312) bouche au moins une deuxième ouverture (116, 216, 316) formant un accès au canal (117, 217) ou à la première ouverture (310), et fermant hermétiquement le volume formé par ladite une des premières cavités (106, 206, 306a - 306c) et la deuxième cavité (115, 215, 315).

14. Procédé selon la revendication 13, comportant en outre, après le dépôt de la portion de matériau getter (112, 218a - 218d, 312), une étape de dépôt d'une couche d'herméticité (120, 220, 314) recouvrant la deuxième partie de la portion de matériau getter (112, 218d, 312).

15. Procédé selon l'une des revendications 10 à 14, comportant en outre la réalisation d'une pluralité d'ouvertures (210, 310) à travers les capots (208, 308a - 308c) et le dépôt d'une ou plusieurs portions de matériau getter (218a - 218d, 312) dans une ou plusieurs deuxièmes cavités (215, 315) formées entre les premières cavités (206, 306a - 306c), les ouvertures (210, 310) faisant communiquer l'intérieur des premières cavités (206, 306a - 306c) avec la ou les portions de matériau getter (218a 218d, 312), au moins une partie de ladite ou desdites portions de matériau getter (218a 218d, 312) étant disposées sur le support (104) et/ou contre une ou plusieurs parois latérales extérieures des premières cavités (206, 306a - 306c).

16. Procédé selon la revendication 15, dans lequel les ouvertures (310) sont réalisées telles que intérieur de plusieurs premières cavités (306b, 306c) communique via les ouvertures (310) traversant les capots (308b, 308c) desdites premières cavités (306b, 306c).

17. Procédé selon l'une des revendications 15 ou 16, comportant en outre la réalisation d'une couche de matériau getter (312) fermant hermétiquement le ou les volumes formés par les premières cavités (308a - 308c) et la ou les deuxièmes cavités (315).

## Patentansprüche

1. Struktur zur Einkapselung (100, 200, 300) von mehreren elektronischen Vorrichtungen (102, 202, 302a - 302c) in ersten Hohlräumen (106, 206, 306a - 306c), die voneinander durch wenigstens einen Raum getrennt sind, der einen zweiten Hohlraum (115, 215, 315) bildet, wobei
- jeder der ersten Hohlräume (106, 206, 306a - 306c) durch einen Träger (104) und wenigstens eine Kappe (108, 208, 308a - 308c) begrenzt ist, die auf dem Träger (104) angeordnet ist, und worin wenigstens eine der elektronischen Vorrichtungen (102, 202, 302a - 302c) eingekapselt ist,
- wenigstens ein Bereich aus Gettermaterial (112, 218a - 218d, 312) in dem zweiten Hohlraum (115, 215, 315) angeordnet ist, wobei der zweite Hohlraum (115, 215, 315) auf dem Träger (104) und benachbart zu wenigstens einem der ersten Hohlräume (106, 206, 306a - 306c) angeordnet ist,
wobei:
- die Kappe (108, 208, 308a - 308c) von wenigstens einer Öffnung (110, 210, 310) durchsetzt wird, die das Innere des einen der ersten Hohlräume (106, 206, 306a - 306c) mit dem Bereich aus Gettermaterial (112, 218a - 218d, 312) in Verbindung bringt,
- wenigstens ein Teil des Bereichs aus Gettermaterial (112, 218a - 218c, 312) auf dem Träger (104) und/oder gegen wenigstens eine äußere Seitenwand des einen der ersten Hohlräume (106, 206, 306a - 306c) angeordnet ist,
- der eine der ersten Hohlräume (106, 206, 306a - 306c) und der zweite Hohlraum (115, 215, 315) gemeinsam ein dicht abgeschlossenes Volumen bilden,
- die äußere Seitenwand des einen der ersten Hohlräume (106, 206, 306a - 306c) wenigstens eine innere Seitenwand des zweiten Hohlraums (115, 215, 315) bildet.

2. Einkapselungsstruktur (100, 200, 300) nach Anspruch 1, bei der das Volumen, das gebildet wird durch den einen der ersten Hohlräume (106, 206, 306a - 306c) und dem zweiten Hohlraum (115, 215, 315) durch den Bereich aus Gettermaterial (112, 218a - 218d, 312) dicht abgeschlossen ist.

3. Einkapselungsstruktur (300) nach einem der vorhergehenden Ansprüche, bei der die Öffnung (310) eine Oberfläche der Kappe (308a - 308c) durchsetzt, die im Wesentlichen orthogonal bezüglich einer Hauptebene des Trägers (104) ist.

4. Einkapselungsstruktur (100, 200) nach einem der vorhergehenden Ansprüche, bei der das Innere des einen der ersten Hohlräume (106, 206) mit dem Bereich aus Gettermaterial (112, 218a - 218d) über wenigstens einen Raum in Verbindung ist, der einen Kanal (117, 217) zwischen dem einen der ersten Hohlräume (106, 206) und dem zweiten Hohlraum (115, 215) bildet, wobei die Öffnung (110, 210) derart ist, dass sie in den Kanal (117, 217) mündet.

5. Einkapselungsstruktur (100, 200, 300) nach einem der vorhergehenden Ansprüche, bei der wenigstens ein zweiter Teil des Bereichs aus Gettermaterial (112, 218d, 312) wenigstens eine zweite Öffnung (116, 216, 316) verschließt, die einen Zugang zu dem Kanal (117, 217) oder zur ersten Öffnung (310) bildet.

6. Einkapselungsstruktur (100, 200, 300) nach Anspruch 5, bei der der zweite Teil des Bereichs aus Gettermaterial (112, 218d, 312) durch eine Dichtheitsschicht (120, 220, 314) bedeckt ist.

7. Einkapselungsstruktur (200, 300) nach einem der vorhergehenden Ansprüche, bei der die Kappen (208, 308a - 308c) von Öffnungen (210, 310) durchsetzt werden, die das Innere der ersten Hohlräume (206, 306a - 306c) in Verbindung mit einem oder mehreren Bereichen aus Gettermaterial (218a - 218d, 312) bringen, die in einem oder mehreren zweiten Hohlräumen (215, 315) angeordnet sind, die zwischen den ersten Hohlräumen (206, 306a - 306c) gebildet sind, wobei wenigstens ein Teil des oder der Bereiche aus Gettermaterial (218a - 218d, 312) auf dem Träger (104) und/oder gegen eine oder mehrere äußeren Seitenwände der ersten Hohlräume (206, 306a - 306c) angeordnet ist.

8. Einkapselungsstruktur (300) nach Anspruch 7, bei der das Innere mehrerer erster Hohlräume (306b, 306c) über Öffnungen (310) in Verbindung miteinander ist, die die Kappen (308b, 308c) der ersten Hohlräume (306b, 306c) durchsetzen.

9. Einkapselungsstruktur (300) nach einem der Ansprüche 7 oder 8, ferner umfassend eine Schicht aus Gettermaterial (312), die das Volumen oder die Volumina dicht abschließt, das/die durch die ersten Hohlräume (308a - 308c) und den oder die zweiten Hohlraum/Hohlräume (315) gebildet ist/sind.

10. Verfahren zur Herstellung einer Struktur zur Einkapselung (100, 200, 300) mehrerer elektronischer Vorrichtungen (102, 202, 302a - 302c) in ersten Hohlräumen (106, 206, 306a - 306c), die voneinander durch wenigstens einen Raum getrennt sind, der einen zweiten Hohlraum (115, 215, 315) bildet, wenigstens umfassend die folgenden Schritte:
- Realisieren der elektronischen Vorrichtungen (102, 202, 302a - 302c) auf einem Träger (104),
- Realisieren, für jeden der ersten Hohlräume (106, 206, 306a - 306c) wenigstens einer Kappe (108, 208, 308a - 308c) auf dem Träger (104), wobei jeder der ersten Hohlräume (106, 206, 306a - 306c) durch den Träger (104) und die Kappe (108, 208, 308a - 308c) begrenzt ist, und worin wenigstens eine der elektronischen Vorrichtungen (102, 202, 302a - 302c) eingekapselt ist;
- Realisieren wenigstens einer Öffnung (110, 210, 310) durch die Kappe (108, 208, 308a - 308c) hindurch,
- Aufbringen wenigstens eines Bereichs aus Gettermaterial (112, 218a - 218d, 312) in dem zweiten Hohlraum (115, 215, 315), der auf dem Träger (104) und angrenzend an wenigstens einen der ersten Hohlräume (106, 206, 306a - 306c) angeordnet ist, wobei die Öffnung (110, 210, 310) das Innere des einen der ersten Hohlräume (106, 206, 306a - 306c) in Verbindung mit dem Bereich aus Gettermaterial (112, 218a - 218d, 312) bringt, wobei wenigstens ein Teil des ersten Bereichs aus Gettermaterial (112, 218a - 218d, 312) auf dem Träger (104) und/oder gegen wenigstens eine äußere Seitenwand des einen der ersten Hohlräume (106, 206, 306a - 306c) angeordnet ist,
wobei der eine der ersten Hohlräume (106, 206, 306a - 306c) und der zweite Hohlraum (115, 215, 315) gemeinsam ein dicht geschlossenes Volumen bilden, und wobei die äußere Seitenwand des einen der ersten Hohlräume (106, 206, 306a - 306c) wenigstens eine innere Seitenwand des zweiten Hohlraums (115, 215, 315) bildet.

11. Verfahren nach Anspruch 10, bei dem der Bereich aus Gettermaterial (312) derart aufgebracht ist, dass er das Volumen dicht schließt, welches durch den einen der ersten Hohlräume (306) und den zweiten Hohlraum (315) gebildet wird.

12. Verfahren nach Anspruch 10, ferner umfassend, zwischen der Realisierung der Öffnung (110, 210) durch die Kappe (108, 208) hindurch und dem Aufbringen des Bereichs aus Gettermaterial (112, 218a - 218d) die Realisierung wenigstens eines Raums, der einen Kanal (117, 217) zwischen dem einen der ersten Hohlräume (106, 206) und dem zweiten Hohlraum (115, 215) bildet und dazu ausgelegt ist, das Innere des einen der ersten Hohlräume (106, 206) in Verbindung mit dem Bereich aus Gettermaterial (112, 218a - 218d) zu bringen, wobei die Öffnung (110, 210) derart ist, dass sie in den Kanal (117, 217) mündet.

13. Verfahren nach Anspruch 12, bei dem das Aufbringen des Bereichs aus Gettermaterial (112, 218a - 218d, 312) derart realisiert wird, dass wenigstens ein zweiter Teil des Bereichs aus Gettermaterial (112, 218d, 312) wenigstens eine zweite Öffnung (116, 216, 316) verschließt, die einen Zugang zum Kanal (117,217) oder zur ersten Öffnung (310) bildet, und das Volumen dicht schließt, welches durch den einen der ersten Hohlräume (106, 206, 306a - 306c) und den zweiten Hohlraum (115, 215, 315) gebildet wird.

14. Verfahren nach Anspruch 13, ferner umfassend, nach dem Aufbringen des Bereichs aus Gettermaterial (112, 218a - 218d, 312) einen Schritt des Aufbringens einer Dichtheitsschicht (120, 220, 314), die den zweiten Teil des Bereichs aus Gettermaterial (112, 218d, 312) bedeckt.

15. Verfahren nach einem der Ansprüche 10 bis 14, ferner umfassend die Realisierung einer Mehrzahl von Öffnungen (210, 310) durch die Kappen (208, 308a - 308c) hindurch, sowie das Aufbringen eines oder mehrerer Bereiche aus Gettermaterial (218a - 218d, 312) in einem oder mehreren zweiten Hohlräumen (215, 315), die zwischen den ersten Hohlräumen (206, 306a - 306c) gebildet sind, wobei die Öffnungen (210, 310) das Innere der ersten Hohlräume (206, 306a - 306c) in Verbindung mit dem oder den Bereichen aus Gettermaterial (218a - 218d, 312) bringen, wobei wenigstens ein Teil des oder der Bereiche aus Gettermaterial (218a - 218d, 312) auf dem Träger (104) und/oder gegen eine oder mehrere äußere Seitenwände der ersten Hohlräume (206, 306a - 306c) angeordnet ist.

16. Verfahren nach Anspruch 15, bei dem die Öffnungen (310) derart realisiert sind, dass das Innere mehrerer erster Hohlräume (306b, 306c) miteinander in Verbindung ist über die Öffnungen (310), die die Kappen (308b, 308c) der ersten Hohlräume (306b, 306c) durchsetzen.

17. Verfahren nach einem der Ansprüche 15 oder 16, ferner umfassend die Realisierung einer Schicht aus Gettermaterial (312), die das Volumen oder die Volumina dicht abschließt, die durch die ersten Hohlräume (308a - 308c) und den oder die zweiten Hohlräume (315) gebildet ist/sind.

## Claims

1. A structure (100, 200, 300) for encapsulating several electronic devices (102, 202, 302a - 302c) in first cavities (106, 206, 306a - 306c) separated to each other by at least one space forming a second cavity (115, 215, 315), such that:
- each of the first cavities (106, 206, 306a - 306c) is bounded by a support (104) and at least one cap (108, 208, 308a - 308c) provided on the support (104) and wherein at least one of the electronic devices (102, 202, 302a - 302c) is encapsulated,
- at least one portion of getter material (112, 218a - 218d, 312) is arranged in the second cavity (115, 215, 315), the second cavity (112, 215, 315) being arranged on the support (104) and adjacent to at least one of the first cavities (106, 206, 306a - 306c),
in which:
- at least one aperture (110, 210, 310) passes through the cap (108, 208, 308a - 308c) and communicates the inside of said one of the first cavities (106, 206, 306a - 306c) with the portion of getter material (112, 218a - 218d, 312),
- at least one part of said portion of getter material (112, 218a - 218d, 312) is arranged on the support (104) and/or against at least one outer side wall of said one of the first cavities (106, 206, 306a - 306c),
- said one of the first cavities (106, 206, 306a - 306c) and the second cavity (115, 215, 315) form together a hermetically sealed volume,
- the outer side wall of said one of the first cavities (106, 206, 306a - 306c) forms at least one inner side wall of the second cavity (115, 215, 315).

2. The encapsulating structure (100, 200, 300) according to claim 1, wherein the volume formed by said one of the first cavities (106, 206, 306a - 306c) and the second cavity (115, 215, 315) is hermetically sealed by the portion of getter material (112, 218a - 218d, 312).

3. The encapsulating structure (300) according to one of the preceding claims, wherein the aperture (310) passes through a surface of the cap (308a - 308c) which is substantially perpendicular to a main plane of the support (104).

4. The encapsulating structure (100, 200) according to one of the preceding claims, wherein the inside of said one of the first cavities (106, 206) communicates with the portion of getter material (112, 218a - 218d) via at least one space forming a channel (117, 217) between said one the first cavities (106, 206) and the second cavity (115, 215), the aperture (110, 210) being such that it opens into the channel (117, 217).

5. The encapsulating structure (100, 200, 300) according to one of the preceding claims, wherein at least one second part of the portion of getter material (112, 218d, 312) plugs at least one second aperture (116, 216, 316) giving access to the channel (117, 217) or to the first aperture (310).

6. The encapsulating structure (100, 200, 300) according to claim 5, wherein the second part of the portion of getter material (112, 218d, 312) is covered with a sealing layer (120, 220, 314).

7. The encapsulating structure (200, 300) according to one of the preceding claims, wherein apertures (210, 310) passing through the caps (208, 308a - 308c) communicate the inside of the first cavities (206, 306a - 306c) with one or more portions of getter material (218a - 218d, 312) provided in one or more second cavities (215, 315) formed between the first cavities (206, 306a - 306c), at least one part of said portion(s) of getter material (218a - 218d, 312) being provided on the support (104) and/or against one or more outer side walls of the first cavities (206, 306a - 306c).

8. The encapsulating structure (300) according to claim 7, wherein the insides of several first cavities (306b, 306c) communicate together via the apertures (310) passing through the caps (308b, 308c) of said fist cavities (306b, 306c).

9. The encapsulating structure (300) according to one of claims 7 or 8, further including a layer of getter material (312) hermetically sealing the volume(s) formed by the first cavities (308a-308c) and the second cavity or cavities (315).

10. A method for making a structure (100, 200, 300) for encapsulating several electronic devices (102, 202, 302a - 302c) in first cavities (106, 206, 306a - 306c) separated to each other by at least one space forming a second cavity (115, 215, 315), including at least the steps of:
- making the electronic devices (102, 202, 302a - 302c) on a support (104),
- making, for each of the first cavities (106, 206, 306a - 306c), at least one cap (108, 208, 308a - 308c) on the support (104), each of the first cavities (106, 206, 306a - 306c) being bounded by the support (104) and the cap (108, 208, 308a - 308c) and wherein at least one of the electronic devices (102, 202, 302a - 302c) is encapsulated;
- making at least one aperture (110, 210, 310) through the cap (108, 208, 308a - 308c),
- depositing at least one portion of getter material (112, 218a - 218d, 312) in the second cavity (115, 215, 315) arranged on the support (104) and adjacent to at least one of the first cavities (106, 206, 306a - 306c), the aperture (110, 210, 310) communicating the inside of said one of the first cavities (106, 206, 306a - 306c) with the portion of getter material (112, 218a - 218d, 312), at least one part of said portion of getter material (112, 218a - 218d, 312) being arranged on the support (104) and/or against at least one outer side wall of said one of the first cavities (106, 206, 306a - 306c),
wherein said one of the first cavities (106, 206, 306a - 306c) and the second cavity (115, 215, 315) form together a hermetically sealed volume, and wherein the outer side wall of said one of the first cavities (106, 206, 306a - 306c) forms at least one inner side wall of the second cavity (115, 215, 315).

11. The method according to claim 10, wherein the portion of getter material (312) is deposited such that it hermetically seals the volume formed by said one of the first cavities (306) and the second cavity (315).

12. The method according to claim 10, further including, between making the aperture (110, 210) through the cap (108, 208) and depositing the portion of getter material (112, 218a - 218d), making at least one space forming a channel (117, 217) between said one of the first cavities (106, 206) and the second cavity (115, 215) and for communicating the inside of said one the first cavities (106, 206) with the portion of getter material (112, 218a - 218d), the aperture (110, 210) being such that it opens into the channel (117, 217).

13. The method according to claim 12, wherein depositing the portion of getter material (112, 218a - 218d, 312) is made such that at least one second part of the portion of getter material (112, 218d, 312) plugs at least one second aperture (116, 216, 316) giving access to the channel (117, 217) or to the first aperture (310), and hermetically sealing the volume formed by said one of first cavities (106, 206, 306a - 306c) and the second cavity (115, 215, 315).

14. The method according to claim 13, further including, after depositing the portion of getter material (112, 218a - 218d, 312), a step of depositing a sealing layer (120, 220, 314) covering the second part of the portion of getter material (112, 218d, 312).

15. The method according to one of claims 10 to 14, further including making a plurality of apertures (210, 310) through the caps (208, 308a - 308c) and depositing one or more portions of getter material (218a - 218d, 312) into one or more second cavities (215, 315) formed between the first cavities (206, 306a - 306c), the apertures (210, 310) communicating the inside of the first cavities (206, 306a - 306c) with the portion(s) of getter material (218a - 218d, 312), at least one part of said portion(s) of getter material (218a - 218d, 312) being arranged on the support (104) and/or against one or more outer side walls of the first cavities (206, 306a - 306c) .

16. The method according to claim 15, wherein the apertures (310) are made such that the inside of several first cavities (306b, 306c) communicates via the apertures (310) passing through the caps (308b, 308c) of said first cavities (306b, 306c).

17. The method according to one of claims 15 and 16, further including making a layer of getter material (312) hermetically sealing the volume(s) formed by the first cavities (308a - 308c) and the second cavity or cavities (315).
